# EUROPEAN PATENT SPECIFICATION

(11) **EP 1 929 846 B1**
(45) Date of publication and mention of the grant of the patent: **16.08.2017**
(21) Application number: 06790120.7
(22) Date of filing: 31.08.2006
(51) Int. Cl.: H01R 9/05, H01R 12/00, H01R 24/50, H05K 9/00, H01R 103/00, H05K 1/02, H05K 3/32, H05K 3/34

(54) **SYSTEM AND METHOD FOR SHIELDED COAXIAL CABLE ATTACHMENT**
SYSTEM UND VERFAHREN ZUR ABGESCHIRMTEN KOAXIALKABEL-ANBRINGUNG
SYSTÈME ET MÉTHODE POUR UNE FIXATION DE CÂBLE COAXIAL PRÉSENTANT UN ÉLÉMENT DE PROTECTION

(30) Priority: 02.09.2005 US 713698 P; 30.08.2006 US 512970
(43) Date of publication of application: 11.06.2008
(73) Proprietor: Intel Corporation, Santa Clara, CA 95054 (US)
(72) Inventor: PRICE, Russell, Anaheim Hills, CA 92808 (US)
(74) Representative: Goddar, Heinz J.
(86) International application number: PCT/US2006/034022
(87) International publication number: WO 2007/027884

(56) References cited:
- EP-A1- 0 444 567
- EP-A1- 1 596 477
- WO-A2-2005/002298
- US-A- 3 743 748
- US-A- 5 532 659
- US-A1- 2005 250 383
- US-B1- 6 457 979

## Description

### FIELD OF THE INVENTION

The present invention relates to systems and methods for connection of coaxial cables to conductors on a printed circuit board.

### BACKGROUND, PRIOR ART AND RELATED INFORMATION

Coaxial cable is used widely in system configurations where microwave and radio signals are processed. Coaxial cables are terminated using connectors and direct attachment Connectors offer a reliable means of connection but are often costly and introduce additional signal losses. Direct attachment of coaxial cable eliminates cost and the added signal losses but introduces several factors that affect the reliability of the connection and signal Integrity. Soldered connections are susceptible to radiated emissions and need to withstand the imposed environmental conditions to insure connection integrity.

Accordingly, a need exists for an improved system and method for the connection of a coaxial cable to a printed circuit board while preventing radiated emissions.

US 5,532,659 discloses a connection device for providing a coaxial cable connection to a printed circuit board. A conductive connector having an opening receives the coaxial cable.

### SUMMARY OF THE INVENTION

The present invention provides a system for the connection of a coaxial cable to a conductor on a printed circuit board and the ability to prevent parasitic radiation by the inclusion of a shield that mates directly to the connection device.

In a preferred embodiment, the present invention provides a device for connecting a coaxial cable to a printed circuit board, the device comprising a connector comprising an electrically conductive element having a receptacle that captures an end of the coaxial cable for connecting the coaxial cable to a conductor on the printed circuit board, and a shield that mates directly to the connector and the printed circuit board, to prevent parasitic radiation.

In another embodiment, the present invention employs a connection device comprising a single piece metal design that captures the coaxial cable within a circular opening. The connection device attaches to a printed circuit board with fasteners or by direct solder attachment to the top surface of a printed circuit board and provides a surface for an external cover to encapsulate the radiated emissions. The present connection device can be used for a variety of coaxial cables by varying the hole diameter and connection device dimensions and can accommodate both stripline and microstrip structures contained in a printed circuit board.

Further features and aspects of the invention are described in the following detailed description.

### BRIEF DESCRIPTION OF THE DRAWINGS

Figure 1 is an exploded view showing the connecting device in a preferred embodiment of the invention.
Figure 2 is an assembled view of the connecting device of Figure 1.
Figure 3 is a cross sectional view of the connecting device of Figure 1.

### DETAILED DESCRIPTION OF THE INVENTION

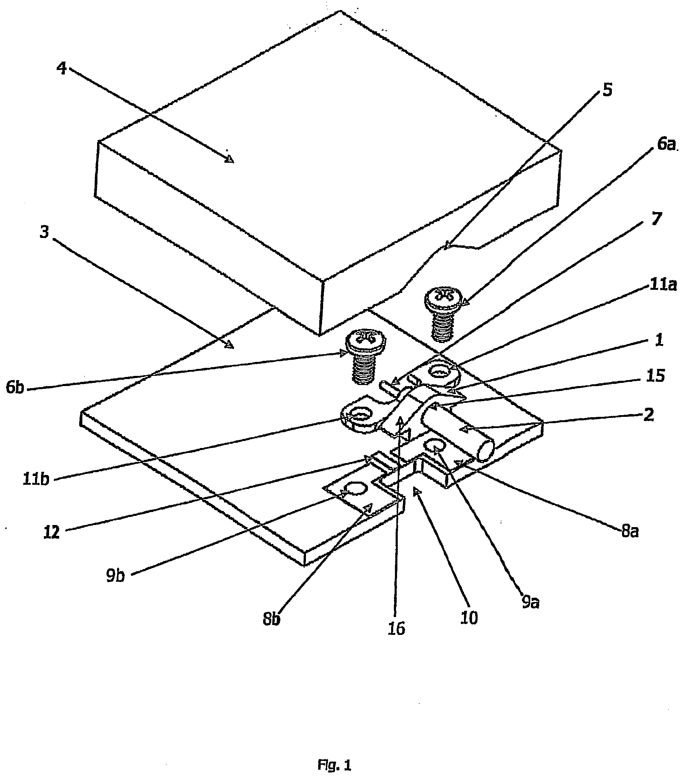

Fig. 1 is an exploded view showing the coaxial cable 2, printed circuit board 3, emission cover 4 and the connection device 1 that is used to connect the end of the coaxial cable 2 to the printed circuit board and provide an interface 16 to the emission cover 4. The end of the coaxial cable 2 is bared in order to reveal the center conductor 7 of the coaxial cable 2. In the example described, the center conductor 7 of the coaxial cable 2 is attached to the microstrip conductor 12 on the printed circuit board 3.

The coaxial cable 2 is fed through a circular hole 15 in the connection device 1. The circular hole is designed to capture the coaxial cable 2 and locate the center conductor 7 of the coaxial cable 2 relative to the microstrip conductor 12 on the printed circuit board to allow for a sufficient solder joint to connect.

The printed circuit board 3 is designed with a notch 10 to center and align the connection device 1 to the microstrip conductor 12 on the printed circuit board 3. The connection device 1 is designed to fit within the notch 10 in the printed circuit board 3.

On both sides of the notch 10 in the printed circuit board 3 are two circular clearance holes 9a, 9b that align with two circular clearance holes 11 a, 11 b in the connection device 1. Screws 6a, 6b are used to attach through both sets of clearance holes 9a, 9b, 11 a, 11 b to a mounting surface for the printed circuit board 3. The connection device 1 rests on the ground pads 8a, 8b on the printed circuit board 3 that are grounded to the mounting surface.

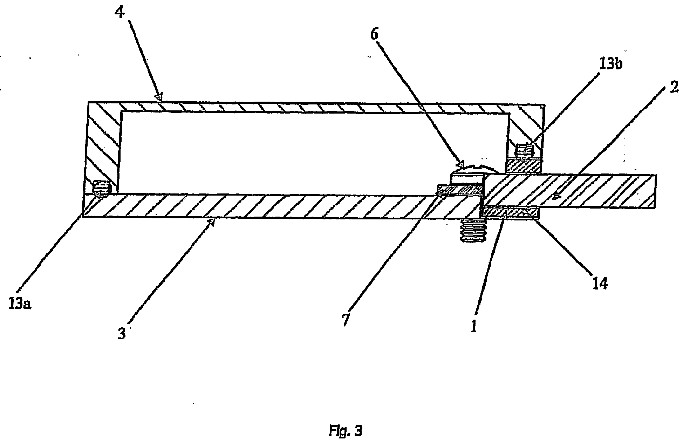

Fig. 3 shows the cross sectional view taken along the centerline of the coaxial cable 2. The interface between the cover 4 and the connection device 1 is an EMI gasket 13b. The EMI gasket 13b rests between the gasket interface 16 of the connection device 1 and the cover interface 5. The EMI gasket 13a, 13b prevents any emissions of the signals on the printed circuit board and emissions into the cavity formed by the cover 4.

The connection device 1 is preferably an integral unit that can be made by machining or casting. Casting is the preferred method for cost reasons. The connection device 1 is solder plated to ground the outer jacket of the coaxial cable 2. When the connection device 1 and coaxial cable are heated, a soldered connection 14 forms between the coaxial cable 2 and the connection device 1.

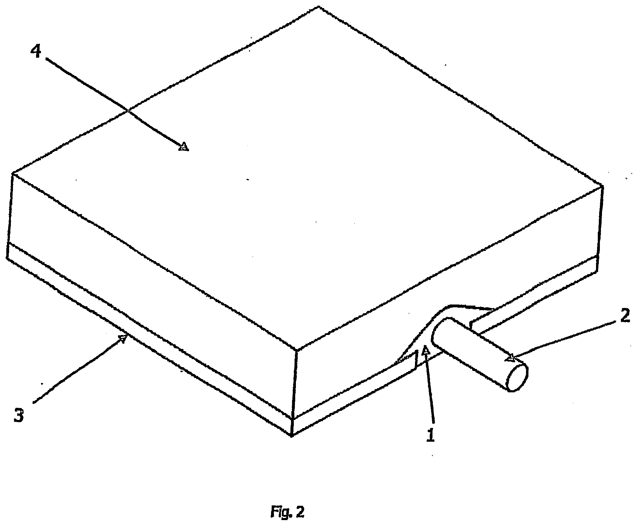

The completed assembly showing the connection device 1, coaxial cable 2, printed circuit board 3 and the cover 4 is shown in Fig. 2.

The present invention is not limited to the example described. The invention can also be used for stripline conductors on a printed circuit board 3. In this instance, the notch 10 in the printed circuit board 3 would be extended to allow for a stripline tab to protrude from the end of the notch 10. The circular hole 15 in the connection device 1 would be adjusted for the height difference of the stripline conductor.

Similarly, other attachment methods for the connection device 1 could be employed. The connection device 1 is designed to be mounted to the printed circuit board 3 using surface mount technology (SMT). The connection device 1 could be hard fitted into the notch 10 in the printed circuit board 3 or held in place with two pins inserted into the clearance holes 9a, 9b of the printed circuit board 3 that would feed through the clearance holes 11 a, 11 b of the connection device. These methods would restrain the connection device 1 and allow the connection device 1 to be solder reflowed in a similar matter that electronic components are attached to a printed circuit board 3.

In another aspect the present invention further provides a method for assembly and shielding of a coaxial cable and a printed circuit board, comprising the steps of: providing a single piece conductive connector having the circular opening and the outer surface; capturing the coaxial cable within the circular opening of the conductive connector; attaching the connector with the attached coaxial cable to a surface of the printed circuit board; and attaching a cover having integrated metallic shield walls, to the surface of the connector and a surface of the circuit board, to encapsulate and shield radiated emissions from the circuit board and the coaxial cable. Preferably, a conductive gasket is contained within the walls of the cover and the shielding is provided without soldering the walls to the circuit board. Further, attaching the connector comprises use of fasteners or direct solder attachment to a top surface of the printed circuit board.

A number of additional modifications are possible within the scope of the present invention, as will be appreciated by those skilled in the art.

## Claims

1. A printed circuit board and a device for connecting a coaxial cable (2) to the printed circuit board (3), the device comprising:
a connection device (1) comprising an electrically conductive element having a receptacle opening (15) for capturing an end of the coaxial cable for connecting the coaxial cable to a microstrip conductor (12) on the printed circuit board; and
an emission cover (4) that mates directly to the connection device (1) and the printed circuit board (3), to prevent parasitic radiation, **characterized by** the emission cover (4) entirely covering the top surface of the connection device (1) and the printed circuit board (3).

2. The printed circuit board and device of claim 1 wherein the receptacle opening is a circular opening.

3. The printed circuit board and device of claim 1 wherein the connection device (1) includes a surface (16) for interface with the emission cover (4) and the emission cover (4) includes a corresponding surface interface (5) to receive the connection device (1) ; such that when the connection device (1) is attached to the printed circuit board (3), and the emission cover (4) is positioned on the printed circuit board (3) and on the connection device (1), the emission cover (4) forms a cavity around the connection device (1) and a circuit on the printed circuit board (3), to encapsulate radiated emissions.

4. The printed circuit board and device of claim 3 wherein the cover shields emissions from electrical signals on the printed circuit board and shields emissions into the cavity formed by the cover.

5. The printed circuit board and device of claim 4 further comprising a first EMI gasket (13b) between the interface surface (16) and said corresponding surface interface (5) of the emission cover (4), to encapsulate emissions from electrical signals on the printed circuit board (3) and emissions into the cavity formed by the emission cover (4).

6. The printed circuit board and device of claim 5 further comprising a second EMI gasket (13a) between the printed circuit board (3) and the emission cover (4), thereby encapsulating emissions from electrical signals on the printed circuit board (3) and emissions into the cavity formed by the emission cover (4).

7. The printed circuit board and device of claim 1 wherein the connection device (1) comprises a single piece conductive element.

8. The printed circuit board and device of claim 7 wherein the conductive element comprises a conductive metal casting.

9. The printed circuit board and device of claim 1 wherein the printed circuit board (3) has a notch (10) to center and align the connection device (1) to said microstrip conductor (12) on the printed circuit board (3).

10. The printed circuit board and device of claim 9 wherein, when assembled to the printed circuit board (3), the connection device (1) rests on ground pads (8a, 8b) on the printed circuit board (3) that are grounded.

11. The printed circuit board and device of claim 10 wherein the connection device (1) attaches to the printed circuit board (3) with screws (6a, 6b).

12. The printed circuit board and device of claim 11 wherein the connection device (1) attaches to the printed circuit board (3) by direct solder attachment to the top surface of the printed circuit board (3).

## Patentansprüche

1. Leiterplatte und Vorrichtung zum Verbinden eines Koaxialkabels (2) mit der Leiterplatte (3), wobei die Vorrichtung Folgendes umfasst:
eine Verbindungsvorrichtung (1), die ein elektrisch leitfähiges Element mit einer Aufnahmeöffnung (15) zum Fassen eines Endes des Koaxialkabels zum Verbinden des Koaxialkabels mit einem Mikrostreifenleiter (12) auf der Leiterplatte umfasst; und
eine Emissionsabdeckung (4), die direkt mit der Verbindungsvorrichtung (1) und der Leiterplatte (3) zusammengefügt wird, um eine parasitäre Strahlung zu verhindern, **dadurch gekennzeichnet, dass** die Emissionsabdeckung (4) die obere Oberfläche der Verbindungsvorrichtung (1) und der Leiterplatte (3) vollständig bedeckt.

2. Leiterplatte und Vorrichtung nach Anspruch 1, wobei die Aufnahmeöffnung eine kreisförmige Öffnung ist.

3. Leiterplatte und Vorrichtung nach Anspruch 1, wobei die Verbindungsvorrichtung (1) eine Oberfläche (16) als Berührungsfläche zu der Emissionsabdeckung (4) beinhaltet und die Emissionsabdeckung (4) eine entsprechende Oberflächenberührungsfläche (5) zum Aufnehmen der Verbindungsvorrichtung (1) beinhaltet; so dass, wenn die Verbindungsvorrichtung (1) an der Leiterplatte (3) angebracht ist und die Emissionsabdeckung (4) auf der Leiterplatte (3) und auf der Verbindungsvorrichtung (1) positioniert ist, die Emissionsabdeckung (4) einen Hohlraum um die Verbindungsvorrichtung (1) und einen Schaltkreis auf der Leiterplatte (3) herum bildet, um abgestrahlte Emissionen einzukapseln.

4. Leiterplatte und Vorrichtung nach Anspruch 3, wobei die Abdeckung Emissionen von elektrischen Signalen auf der Leiterplatte abschirmt und Emissionen in den Hohlraum hinein, der durch die Abdeckung gebildet wird, abschirmt.

5. Leiterplatte und Vorrichtung nach Anspruch 4, die ferner eine erste EMI-Dichtung (13b) zwischen der Berührungsflächenoberfläche (16) und der entsprechenden Oberflächenberührungsfläche (5) der Emissionsabdeckung (4) umfassen, um Emissionen von elektrischen Signalen auf der Leiterplatte (3) und Emissionen in den Hohlraum hinein, der durch die Emissionsabdeckung (4) gebildet wird, einzukapseln.

6. Leiterplatte und Vorrichtung nach Anspruch 5, die ferner eine zweite EMI-Dichtung (13a) zwischen der Leiterplatte (3) und der Emissionsabdeckung (4) umfassen, wodurch Emissionen von elektrischen Signalen auf der Leiterplatte (3) und Emissionen in den Hohlraum hinein, der durch die Emissionsabdeckung (4) gebildet wird, eingekapselt werden.

7. Leiterplatte und Vorrichtung nach Anspruch 1, wobei die Verbindungsvorrichtung (1) ein leitfähiges Element aus einem einzigen Stück umfasst.

8. Leiterplatte und Vorrichtung nach Anspruch 7, wobei das leitfähige Element einen leitfähigen Metallguss umfasst.

9. Leiterplatte und Vorrichtung nach Anspruch 1, wobei die Leiterplatte (3) eine Aussparung (10) aufweist, um die Verbindungsvorrichtung (1) bezüglich des Mikrostreifenleiters (12) auf der Leiterplatte (3) zu zentrierten und auszurichten.

10. Leiterplatte und Vorrichtung nach Anspruch 9, wobei die Verbindungsvorrichtung (1), wenn sie mit der Leiterplatte (3) zusammengefügt ist, auf Massepads (8a, 8b) auf der Leiterplatte (3), die masseverbunden sind, aufliegt.

11. Leiterplatte und Vorrichtung nach Anspruch 10, wobei die Verbindungsvorrichtung (1) mit Schrauben (6a, 6b) an der Leiterplatte (3) angebracht wird.

12. Leiterplatte und Vorrichtung nach Anspruch 11, wobei die Verbindungsvorrichtung (1) durch eine direkte Lötbefestigung an der oberen Oberfläche der Leiterplatte (3) an der Leiterplatte (3) angebracht wird.

## Revendications

1. Carte de circuit imprimé et dispositif pour connecter un câble coaxial (2) à la carte de circuit imprimé (3), le dispositif comprenant :
un dispositif de connexion (1) comprenant un élément électriquement conducteur ayant une ouverture de réception (15) pour capturer une extrémité du câble coaxial afin de connecter le câble coaxial à un conducteur en microruban (12) sur la carte de circuit imprimé ; et
un couvercle d'émission (4) qui s'accouple directement au dispositif de connexion (1) et à la carte de circuit imprimé (3), pour empêcher le rayonnement parasite, **caractérisé en ce que**
le couvercle d'émission (4) recouvre entièrement la surface supérieure du dispositif de connexion (1) et de la carte de circuit imprimé (3).

2. Carte de circuit imprimé et dispositif de la revendication 1, l'ouverture de réception étant une ouverture circulaire.

3. Carte de circuit imprimé et dispositif de la revendication 1, le dispositif de connexion (1) comportant une surface (16) servant d'interface avec le couvercle d'émission (4) et le couvercle d'émission (4) comportant une interface de surface correspondante (5) pour recevoir le dispositif de connexion (1) ; de telle sorte que, lorsque le dispositif de connexion (1) est fixé à la carte de circuit imprimé (3), et le couvercle d'émission (4) est positionné sur la carte de circuit imprimé (3) et sur le dispositif de connexion (1), le couvercle d'émission (4) forme une cavité autour du dispositif de connexion (1) et d'un circuit sur la carte de circuit imprimé (3), pour encapsuler les émissions rayonnées.

4. Carte de circuit imprimé et dispositif de la revendication 3, le couvercle protégeant des émissions provenant de signaux électriques sur la carte de circuit imprimé et protégeant des émissions dans la cavité formée par le couvercle.

5. Carte de circuit imprimé et dispositif de la revendication 4 comprenant en outre un premier joint EMI (13b) entre la surface d'interface (16) et ladite interface de surface correspondante (5) du couvercle d'émission (4), pour encapsuler les émissions provenant de signaux électriques sur la carte de circuit imprimé (3) et les émissions dans la cavité formée par le couvercle d'émission (4).

6. Carte de circuit imprimé et dispositif de la revendication 5 comprenant en outre un deuxième joint EMI (13a) entre la carte de circuit imprimé (3) et le couvercle d'émission (4), encapsulant ainsi les émissions provenant de signaux électriques sur la carte de circuit imprimé (3) et les émissions dans la cavité formée par le couvercle d'émission (4).

7. Carte de circuit imprimé et dispositif de la revendication 1, le dispositif de connexion (1) comprenant un élément conducteur d'une seule pièce.

8. Carte de circuit imprimé et dispositif de la revendication 7, l'élément conducteur comprenant un moulage métallique conducteur.

9. Carte de circuit imprimé et dispositif de la revendication 1, la carte de circuit imprimé (3) ayant une encoche (10) pour centrer et aligner le dispositif de connexion (1) sur ledit conducteur en microruban (12) sur la carte de circuit imprimé (3).

10. Carte de circuit imprimé et dispositif de la revendication 9, le dispositif de connexion (1), une fois assemblé à la carte de circuit imprimé (3), reposant sur des plots de terre (8a, 8b) sur la carte de circuit imprimé (3) qui sont mis à la terre.

11. Carte de circuit imprimé et dispositif de la revendication 10, le dispositif de connexion (1) se fixant à la carte de circuit imprimé (3) avec des vis (6a, 6b).

12. Carte de circuit imprimé et dispositif de la revendication 11, le dispositif de connexion (1) se fixant à la carte de circuit imprimé (3) par une fixation par brasage direct à la surface supérieure de la carte de circuit imprimé (3).
